# EUROPÄISCHE PATENTSCHRIFT

(11) **EP 3 607 419 B1**
(45) Veröffentlichungstag und Bekanntmachung des Hinweises auf die Patenterteilung: **17.07.2024**
(21) Anmeldenummer: 18723410.9
(22) Anmeldetag: 03.04.2018
(51) Int. Cl.: G06F 3/01, G06F 30/00

(54) **VERFAHREN UND VORRICHTUNG ZUR DARSTELLUNG EINER BAUTEILDOKUMENTATION**
METHOD AND DEVICE FOR DISPLAYING COMPONENT DOCUMENTATION
PROCÉDÉ ET DISPOSITIF DE REPRÉSENTATION D'UNE DOCUMENTATION DE PIÈCES

(30) Priorität: 04.04.2017 DE 102017107224
(43) Veröffentlichungstag der Anmeldung: 12.02.2020
(73) Patentinhaber: Deutsches Zentrum für Luft- und Raumfahrt e.V., 51147 Köln (DE)
(72) Erfinder: STEFFEN, Olaf, 22763 Hamburg (DE); KOLBE, Andreas, 22305 Hamburg (DE); HASCHENBURGER, Anja, 21682 Stade (DE); SCHREIBER, Markus, 21680 Stade (DE)
(74) Vertreter: Gramm, Lins & Partner Patent- und Rechtsanwälte PartGmbB
(86) Internationale Anmeldenummer: PCT/EP2018/058445
(87) Internationale Veröffentlichungsnummer: WO 2018/185077

(56) Entgegenhaltungen:
- WO-A1-2016/130160
- DE-A1- 10 128 016
- DE-A1- 10 244 691
- DE-A1- 102013 107 214
- DE-A1- 102015 006 632
- DE-B4- 10 128 016
- US-A1- 2002 049 775
- US-A1- 2002 191 002
- US-A1- 2013 046 592
- US-A1- 2016 328 883

## Beschreibung

Die Erfindung betrifft ein Verfahren und eine Vorrichtung zur Darstellung einer Bauteildokumentation bezüglich der Planung, Fertigung und/oder Wartung eines Bauteils.

Die in der Fertigung gestellte Forderung nach einer Steigerung der Produktivität bei gleichbleibend hoher Bauteilqualität führt zu einer Zunahme des Automatisierungsgrades und zu einer Abnahme des Fertigungspersonals. Das eingesetzte Personal diente dabei häufig der Überwachung des aktuellen Fertigungsprozesses, dem Einstellen der optimalen Fertigungsparameter und der Bestückung der Fertigungseinrichtungen. Im Gegensatz zur manuellen Bauteilfertigung, wie beispielsweise bei der Fertigung von Faserverbundbauteilen aus einem Faserverbundwerkstoff, sind die Prozesstoleranzen und die Streuung der Bauteilqualität geringer, jedoch sind Prozessabweichungen und Prozessfehler bei komplexen Fertigungstechnologien aufgrund der Vielzahl von Parametern nur schwer für den Anlagenbediener zu erfassen.

Insbesondere im Bereich der Faserverbundfertigung ist in den letzten Jahren eine stetige Zunahme des Automatisierungsgrades zu beobachten, wobei hierbei Fertigungstechnologien wie Automated Fiber Placement (AFP), Dry Fiber Placement (DFP) und Automated Tape Laying (ATL) zum Einsatz kommen. Mit der Zunahme der Ablegegeschwindigkeit und insbesondere bei Einsatz von Mehrkopfanlagen wird die Überwachung derartiger Fertigungsprozesse für den Anlagenbediener zunehmend schwieriger bis hin unmöglich.

Aus der WO 2016/130160 A1 ist ein System zum Überwachen einer Ölfeldbohrung bekannt, wobei Informationen diesbezüglich aus einer Bohranlage erfasst und mit Hilfe von tragbaren Projektionsbrillen den einzelnen Bedienern angezeigt werden können.

Aus der DE 10 2015 204 181 A1 ist eine Datenbrille für busfähige Gerätebauteile bekannt, die zur Erfassung, Änderung und Diagnose von Betriebsparametern von busfähigen oder zur drahtlosen Kommunikation geeignet ausgestalteten Gerätebauteilen ausgebildet ist.

Die Menge der Daten mittels konventioneller Anzeigesysteme ist bei hochautomatisierten Fertigungsanlagen für den Anlagenbediener kaum noch beherrschbar. Darüber hinaus verhindert die gegenwärtige Form der Dokumentation von Prozessschritten und Prozessdaten in getrennten Dokumenten eine konsistente Bauteildokumentation und einen einfachen Zugang zu den Informationen betreffend ein spezifisches Bauteil, was durch die Fertigungsautomation eingesparten Kosten zum Teil wieder aufzehren.

Außerdem verhindert die aus dem Stand der Technik bekannte und in der Praxis aktuell angewendete Darstellung der Bauteildokumentation eine integrierte Fehleranalyse während der Fertigung insbesondere bei hochautomatisierten Fertigungsprozessen, wie beispielweise der automatisierten Faserablage bei der Herstellung eines Faserverbundbauteils, was die Fehleranalyse erschwert und den Prozess zunehmend ineffektiv mit dem Grad der Automation macht.

Die DE 101 28 016 A1 offenbart eine Anlage zur Produktion von Gütern und ein Verfahren zum Einrichten der Anlage, wobei mithilfe einer Projektionsbrille entsprechende Einrichtungsdaten beim Einrichten eines Werkzeugs gemäß Sichtfeld des Arbeiters projiziert werden sollen. Dabei wird auch die Soll-Position des Werkzeugs innerhalb der Anlage über eine "augmented reality" in das Blickfeld des Arbeiters projiziert, um so das Einrichten der Anlage zu vereinfachen.

Die DE 102 44 691 A1 offenbart ein Verfahren zum Aufbau eines Technikträgers für neu zu entwickelnde Fahrzeugkomponenten, wobei auch hier mithilfe einer Projektionsbrille die reale Umgebung erweitert werden soll. Ein virtuelles Modell einer neu zu entwickelnden Fahrzeugkomponente wird so in das Sichtfeld des Anwenders projiziert, dass dieser das virtuelle Modell innerhalb des Technikträgers an der Position wahrnimmt, an der es später auch einmal eingebaut werden soll.

Die US 2002/0049775 A1 offenbart die Darstellung einer Bedienungsanleitung mittels eines "augmented reality" Systems in das Sichtfeld eines Arbeiters.

Die US 2016/328883 A1 offenbart ein System für eine augmented reality für Fahrzeuge, um Zusatzinformationen zu den Fahrzeugen anzeigen zu können. Dabei kann auch eine 3-dimensionale Repräsentation des Fahrzeuges vorgesehen dargestellt werden. Es können Wartungsmaßnahmen und Instandhaltungen während der Lebenszeit des Fahrzeuges in die digitale Repräsentation des Fahrzeuges hinterlegt und bei Bedarf angezeigt werden.

Aus der US 2013/046592 A1 ist ebenfalls eine augmented reality für Fahrzeuge bekannt, bei der Zusatzinformationen zu einem bereits bestehenden Fahrzeug in das Sichtfeld des Anwenders projiziert werden, umso beispielsweise Wartungsmaßnahmen zu verbessern oder Informationen zielgenau anzeigen zu können.

Schließlich offenbar die US 2002/191002 A1 ein Verfahren und eine Vorrichtung für eine remote Unterstützung bei der Fehlersuche in einer technischen Anlage. Der Anwender vor Ort hat dabei eine augmented reality Brille, deren Kameradaten an einen entfernt platzierten Operateur übertragen werden. Dieser kann nun Hilfestellungen bei der Fehlersuche oder Wartungsmaßnahmen geben, indem beispielsweise dem Anwender vor Ort entsprechende Hilfestellungen in das Blickfeld eingeblendet werden.

Es ist daher Aufgabe der vorliegenden Erfindung eine verbesserte Vorrichtung und ein verbessertes Verfahren zur Darstellung einer Bauteildokumentation bezüglich der Planung, Fertigung und/oder Wartung eines Bauteils anzugeben, um so insbesondere die der Dokumentation innewohnende Komplexität basierend auf der hochautomatisierten Fertigungsanlage reduzieren zu können.

Die Aufgabe wird mit dem Verfahren gemäß Anspruch 1 sowie der Vorrichtung gemäß Anspruch 7 erfindungsgemäß gelöst.

Gemäß Anspruch 1 wird ein Verfahren zur Darstellung einer Bauteildokumentation bezüglich der Planung, Fertigung und/oder Wartung eines Bauteils vorgeschlagen, wobei hierfür eine Bauteildokumentation bereitgestellt wird, die in einem digitalen Datenspeicher hinterlegt ist. Die hinterlegte virtuelle Bauteildokumentation enthält dabei eine Mehrzahl von Planungs-, Fertigungs- und/oder Wartungsdaten bezüglich der Planung, Fertigung und/oder Wartung des Bauteils, dessen Bauteildokumentation dargestellt werden soll, die in den jeweiligen Planungs-, Fertigungs-, und/oder Wartungsprozessen erfasst und entsprechend dokumentiert wurden. Die Bauteildokumentation enthält des Weiteren Modelldaten des Bauteils, wodurch seine Form und/oder Geometrie, insbesondere seine dreidimensionale Form und/oder Geometrie ermittelbar ist.

Bei der Herstellung eines Faserverbundbauteils aus einem Faserverbundwerkstoff, der ein Matrixmaterial und ein Fasermaterial aufweist, wobei das Fasermaterial an das Matrixmaterial eingebettet und zusammen mit diesem nach dem Aushärten des Matrixmaterials eine integrale Einheit bildet, sind Fertigungsdaten insbesondere die Legegeschwindigkeit und der Anpressdruck, wenn das Faserverbundbauteil, insbesondere die Preform, in einem automatisierten Faserlegeprozess wie ATL oder AFP erstellt wurde. Fertigungsdaten können bei der Herstellung eines Faserverbundbauteils aber auch Fehlerdokumentationen sein, die durch automatisierte Fehlererkennungsprozesse während der Fertigung erstellt wurden. Hierbei handelt es sich insbesondere um Ablagefehler bei der automatisierten Ablage des Fasermaterials, die beispielsweise durch Materialfehler oder Fehler während der Ablage entstehen. Hier seien beispielsweise Lücken zwischen zwei abgelegten Faserbahnen genannt. Werden innerhalb eines Vakuumaufbaus mit Hilfe entsprechender Systeme Leckagen identifiziert (beispielsweise mittels Thermographiesystemen), so können diese identifizierten Leckagen ebenfalls als Fertigungsdaten in die Bauteildokumentation mit aufgenommen werden, sodass sie der virtuellen Bauteildokumentation zur Verfügung stehen. Als Teil der Bauteildokumentation kommen aber auch Anlagen- und externe Sensordaten wie beispielsweise Temperatur, Luftfeuchte, Anpressdruck sowie Daten über das verwendete Material in Betracht.

Des Weiteren wird eine Projektionsvorrichtung bereitgestellt, die wenigstens eine Projektionsbrille hat, die eine vor den Augen einer Person zu tragende Brillenkonstruktion ist und eine Projektion von virtuellen Abbildungen in die Umgebung des Blickfeldes der die Projektionsbrille tragenden Person erzeugen kann. Eine solche Projektionsbrille kann beispielsweise die von der Firma Microsoft entwickelte und unter dem Handelsnamen "Hololens" bekannte Projektionsbrille sein, die in die Umgebung des Blickfeldes der die Projektionsbrille tragende Person dreidimensionale Abbildungen projizieren kann, die sodann der durch die Person betrachteten Umgebung quasi virtuell hinzugefügt werden. Für die die Projektionsbrille tragende Person wird somit durch die dreidimensionale Abbildung, die durch die Projektionsbrille erzeugt wird, die reale Umgebung durch die dreidimensionale Projektion erweitert, sodass man auch von "augmented reality" spricht.

In der Regel weist die Projektionsvorrichtung hierfür eine Recheneinheit auf, die mit der Projektionsbrille verbunden ist (beispielsweise an der Projektionsbrille angeordnet oder entfernt zu dieser angeordnet und über eine Funkverbindung mit dieser verbunden), wobei die Recheneinheit zum Erzeugen von Steuerdaten zur Ansteuerung der Projektionsbrille ausgebildet ist, um so entsprechende virtuelle Abbildungen mit Hilfe der Projektionsbrille erzeugen zu können.

Erfindungsgemäß ist nun des Weiteren vorgesehen, dass eine dreidimensionale Repräsentation des Bauteils aus den in der virtuellen Bauteildokumentation enthaltene Modelldaten des Bauteils mittels einer derartigen Recheneinheit der Projektionsvorrichtung erstellt wird, wird dann mit Hilfe der Projektionsbrille diese dreidimensionale Repräsentation des Bauteils in die Umgebung des Blickfeldes der die Projektionsbrille tragenden Person projiziert wird. Die betreffende Person sieht somit eine dreidimensionale Repräsentation des Bauteils, das beispielsweise gerade in der Fertigung ist, das beispielsweise gerade gewartet werden soll oder das beispielsweise gerade in der Planung ist, was insbesondere dann zum Vorteil ist, wenn die Person keinen physischen Zugriff auf das reale Bauteil hat. Durch die Überlagerung der realen Umwelt durch die dreidimensionale Repräsentation des Bauteils entsteht dabei bei der Person der Eindruck, als wäre das Bauteil tatsächlich da. Dabei kann der Detailgrad der Repräsentation von einer einfachen Umrissdarstellung bis hin zu einer maßstabgetreuen, detaillierten Abbildung reichen.

Schließlich werden zumindest Teile der Bauteildokumentation des Bauteils, dessen dreidimensionale Repräsentation mit Hilfe der Projektionsbrille projiziert wird, dargestellt, indem ein Teil der Planungs-, Fertigungs- und/oder Wartungsdaten hinterlegten virtuellen Bauteildokumentation in die Umgebung des Blickfeldes der die Projektionsbrille tragenden Person in Bezug zur der projizierten dreidimensionalen Repräsentation des Bauteils mit Hilfe der Projektionsbrille projiziert wird. Dabei werden erfindungsgemäß die Planungs-, Fertigungs- und/oder Wartungsdaten, die als Teil der Bauteildokumentation bezüglich des dargestellten Bauteils angezeigt werden sollen, insbesondere positionstreu in Bezug zu der dreidimensionalen Repräsentation des Bauteils dargestellt, sodass beispielsweise Fehlerdaten auch an der Position innerhalb der Projektion der dreidimensionalen Repräsentation des Bauteils angezeigt werden, an dem laut Bauteildokumentation der Fehler auch dokumentiert ist. Hierdurch wird die Suche und die Erfassung des Fehlers durch den Benutzer deutlich vereinfacht, was insbesondere bei großen, komplexen Bauteilen mit einer Vielzahl von kleinen Einheiten besonders schwierig ist.

Bei der Herstellung eines Faserverbundbauteils, das mit Hilfe von automatisierten Faserlegeprozessen hergestellt wird, kann so beispielweise gezielt diejenige Bahn dargestellt werden, an der durch ein Fehlererkennungssystem ein entsprechender Fehler während des automatisierten Legens erkannt und dokumentiert wurde. Hierdurch wird der Anlagenbediener gezielt auf die Position des Fehlers gelenkt und kann diesen deutlich schneller am realen Bauteil identifizieren.

Zusätzliche Monitore, die überwacht werden müssen, bedarf es dabei nicht. Gerade bei der Herstellung von großen Bauteilen ist dabei die Projektionsbrille von besonderem Vorteil, da sich der Bediener der Anlage dabei frei im Raum bewegen kann und dennoch die entsprechende Bauteildokumentation samt Repräsentation des Bauteils angezeigt bekommt.

Die dreidimensionale Repräsentation des Bauteils dient somit als Benutzeroberfläche zur Projektion von Bauteil- und Fertigungsinformationen (einschließlich irreversibel im Bauteil befindlicher Fehler) und kann darüber hinaus zur Eingabe weiterer im Lebenszyklus des Bauteils auftretende Daten in die Dokumentation genutzt werden.

In einer vorteilhaften Ausführungsform wird mittels der bereitgestellten Projektionsvorrichtung die Position und Orientierung der Projektionsbrille relativ zu einem realen Bauteil, dessen Bauteildokumentation dargestellt werden soll und in der näheren Umgebung der Person angeordnet ist, ermittelt, wobei die dreidimensionale Repräsentation des entsprechenden Bauteils derart in die Umgebung des Blickfeldes der die Projektionsbrille tragenden Person projiziert wird, dass die dreidimensionale Repräsentation des Bauteils mit dem realen Bauteil in Deckung gebracht wird. Die dargestellte und insbesondere in Bezug auf die dreidimensionale Repräsentation positionstreue Darstellung der Bauteildokumentation, insbesondere der Fertigungsdaten wie vorteilhafterweise die Fehlerdaten, werden sodann nicht nur positionstreu bezüglich der dreidimensionalen Repräsentation des Bauteils projiziert durch die Projektionsbrille da hinstellt, sondern auch positionstreu in Bezug auf das reale Bauteil, sodass die Person beispielsweise die Fehlerdaten an dem Bauteil an der Stelle angezeigt bekommt, an der der Fehler in dem Bauteil auch tatsächlich detektiert wurde. Lange Suchprozesse nach der möglichen Fehlerposition entfallen somit.

Erfindungsgemäß sind in dem digitalen Datenspeicher eine Mehrzahl von Bauteildokumentationen verschiedener Bauteile gleichen Typs hinterlegt, wie sie beispielsweise in der Serienproduktion anfallen. Für jedes hergestellte Bauteil existiert dabei in dem digitalen Datenspeicher eine Bauteildokumentation, die vorteilhafterweise zumindest die Planungsdaten und die Fertigungsdaten der Fertigung des jeweiligen Bauteils enthält. Mit Hilfe einer Auswerteeinheit kann sodann ein systematischer Fehler aus fehlerbezogenen Fertigungsdaten der jeweiligen Bauteildokumentation identifiziert werden, indem die Fehler aus den Fertigungsdaten der verschiedenen Bauteildokumentationen ausgelesen und durch Agglomeration der Daten dann ein systematischer Fehler identifiziert werden kann. Ein solcher systematischer Fehler lässt sich sodann als Fehlerdaten bzw. Fehlerinformation in der projizierten Repräsentation des Bauteils darstellen, sodass ein Anlagenbediener schnell einen systematischen Fehler an der entsprechenden Position des Bauteils erkennen und somit feststellen kann, dass hier womöglich ein größeres Problem vorliegt.

Es können auch Bauteile unterschiedlichen Typs hinterlegt sein, wobei für jeden Bauteiltyp ein oder mehrere Bauteildokumentationen für einen oder mehrere Bauteile hinterlegt sein können.

In einer weiteren vorteilhaften Ausführungsform wird mittels der bereitgestellten Projektionsvorrichtung die Position und/oder Orientierung der Projektionsbrille relativ zu einem realen Bauteil und/oder absolut im Raum ermittelt, wobei Planungs-, Fertigungs- und/oder Wartungsdaten aus der hinterlegten virtuellen Bauteildokumentation oder ein möglicher identifizierter systematischer Fehler in Abhängigkeit von der ermittelten Position und/oder Orientierung der Projektionsbrille durch eine Auswähleinheit ausgewählt und die ausgewählten Planungs-, Fertigungs- und/oder Wartungsdaten in Umgebung des Blickfeldes der die Projektionsbrille tragende Position mittels der Projektionsbrille projiziert wird. Somit lassen sich die Daten der Bauteildokumentation gezielt in Abhängigkeit von der Orientierung bzw. in Abhängigkeit von der Position der Projektionsbrille beispielsweise relativ zu einem Bauteil oder absolut im Raum auswählen und nachstellen, sodass bei einer Blickrichtung in Richtung des Bauteils andere Daten in das Blickfeld projiziert werden, als bei einer Blickrichtung entgegengesetztes Bauteils (beispielhaft). Je nach Position und Orientierung lassen sich somit gezielt entsprechende Daten auswählen und in Form einer Bauteildokumentation anzeigen.

In einer weiteren vorteilhaften Ausführungsform werden mittels der bereitgestellten Projektionsvorrichtung entsprechende Sprachausgaben und/oder Gestenbewegungen der die Projektionsbrille tragenden Position erkannt und aufgenommen, wobei die Projektionsvorrichtung bezüglich der Projektion und Abhängigkeit von den erkannten Sprachausgaben und/oder Gestenbewegungen gesteuert wird. Hierdurch kann der Benutzer durch Sprachausgaben bzw. Gestenbewegungen entsprechend die ihn interessierenden Daten der Bauteildokumentation auswählen und anzeigen lassen.

In einer weiteren vorteilhaften Ausführungsform lassen sich Fertigungs- und/oder Wartungsdaten bezüglich des Bauteils mittels einer Sensorvorrichtung erfassen, wobei dann wieder mit Hilfe von Sprachausgaben und/oder Gestenbewegungen, die mittels der bereitgestellten Projektionsvorrichtung erkannt werden, die erfassten Fertigungs- und/oder Wartungsdaten dann in die Bauteildokumentation hinterlegen lassen, sodass während der Fertigung nicht nur die entsprechenden Bauteildaten der die Projektionsbrille tragenden Position angezeigt werden, sondern entsprechende Fertigungsdaten, die während der Fertigung des Bauteils anfallen, in die entsprechende Bauteildokumentation hinterlegen lassen. An dieser Stelle würde somit die Projektionsvorrichtung, im Besonderen die Projektionsbrille, als Eingabegerät zur Eingabe von Fertigungsdaten in die Bauteildokumentation fungieren. Selbiges gilt auch für entsprechende Wartungsdaten bei der Wartung eines solchen Bauteils im späteren Lifecycleprozess.

Im Übrigen wird die Aufgabe auch mit der Vorrichtung gemäß Anspruch 7 erfindungsgemäß gelöst, wobei die Vorrichtung hier die bereits beim Verfahren zur Durchführung notwendigen Vorrichtungen und Geräte hat.

Die Erfindung wird anhand der beigefügten Figuren beispielhaft erläutert. Es zeigen:
- Figur 1 -: schematische Darstellung der erfindungsgemäßen Vorrichtung;
- Figur 2 -: schematische Darstellung einer überlagerten Bauteilrepräsentation.

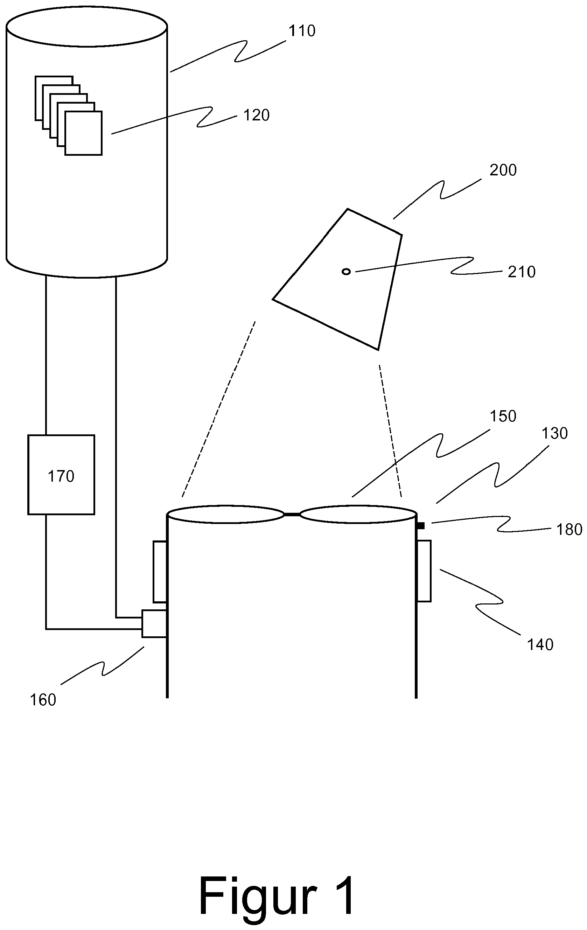

Figur 1 zeigt eine Vorrichtung 100, mit der eine Bauteildokumentation bezüglich der Planung, Fertigung und/oder Wartung eines Bauteils einer nicht dargestellten Person dargestellt werden soll. Hierfür weist die Vorrichtung zunächst einen Datenspeicher 110 auf, der eine Mehrzahl von Bauteildokumentationen 120 bezüglich verschiedener Bauteile enthält. Die Bauteile können dabei alle vom gleichen Bauteiltyp sein. Denkbar ist aber auch, dass jeweils ein Teil der hinterlegten Bauteildokumentationen zu Bauteilen gleichen Typs gehören, so dass auch unterschiedliche Bauteiltypen berücksichtigt werden.

Die Vorrichtung weist des Weiteren eine Projektionsbrille 130 auf, die zur Projektion von virtuellen Abbildungen in die Umgebung der die Projektionsbrille 130 tragenden Person vorgesehen ist. Hierfür weist die Projektionsbrille 130 ein Projektionsmodul 140 auf, mit der die eigentliche Projektion der Abbildung erfolgt. Das geschieht in der Regel dadurch, dass die Gläser 150 der Projektionsbrille 130 als Projektionsfläche dienen, sodass bei dem Betrachter, also der Person, welche die Projektionsbrille 130 trägt, der Eindruck entsteht, dass auf die Gläser eine 50 projizierte Objekt befinde sich tatsächlich in der Umgebung (ähnlich einem Headup-Display).

Des Weiteren weist die Projektionsbrille 130 eine Recheneinheit 160 auf, die anhand von Daten eine entsprechende Projektion generiert und dann das Projektionsmodul 140 so ansteuert, dass die entsprechende Abbildung wie gewünscht in die Umgebung des Blickfeldes der die Projektionsbrille 130 tragenden Person erzeugt wird. Die Recheneinheit 160 ist dabei im Ausführungsbeispiel der Figur 1 an der Projektionsbrille 130 angeordnet. Selbstverständlich ist auch denkbar, dass die Recheneinheit 160 nicht an der Projektionsbrille 130 angeordnet ist und das Projektionsmodul 140 mit der Recheneinheit 160 signaltechnisch in Verbindung steht.

Die Recheneinheit 160 ist so ausgebildet, dass sie aus dem Datenspeicher 110 eine entsprechende Bauteildokumentation 120 abruft und dann zumindest einen Teil der Planungs-, Fertigungs- und/oder Wartungsdaten des Bauteils einschließlich der Modelldaten des Bauteils abruft. Basierend auf den abrufenden Modelldaten wird sodann eine dreidimensionale Repräsentation des Bauteils erstellt und mit Hilfe des Projektionsmoduls 140 der Projektionsbrille 130 in die Umgebung des Blickfeldes der Person projiziert. Eine solche dreidimensionale Repräsentation des Bauteils ist in Figur 1 mit 200 gekennzeichnet.

Der Benutzer der Projektionsbrille 130 erkennt somit die dreidimensionale Repräsentation 200 des Bauteils, wobei erfindungsgemäß weitere Daten innerhalb dieser Repräsentation 200 angezeigt werden. Hierfür wird durch die Recheneinheit 160 ein Teil der Planungs-, Fertigungs-, und/oder Wartungsdaten der ausgewählten Bauteildokumentation in der dreidimensionalen Repräsentation 200 des Bauteils dargestellt, indem diese Daten ebenfalls mit in die dreidimensionale Repräsentation 200 projiziert werden. So lassen sich beispielsweise Fehler innerhalb des Bauteils darstellen, indem positionstreu dieser Fehler 210 in Form einer Repräsentation von Fehlerdaten positionstreu innerhalb der dreidimensionalen Repräsentation 200 des Bauteils angezeigt wird.

Erfindungsgemäß ist dabei des Weiteren vorgesehen, dass die Vorrichtung 100 eine Auswerteeinheit 170 hat, mit der sich beispielsweise systematische Fehler erkennen lassen. Hierfür ruft die Auswerteeinheit 170 die Bauteildokumentation in 120, die dem Datenspeicher 110 hinterlegt sind, ab und untersucht die darin enthaltenen Daten hinsichtlich von Gemeinsamkeiten, was insbesondere den Fehlertyp und die Position des Fehlers innerhalb des Bauteils betrifft. Wurde beispielsweise erkannt, dass in allen oder zumindest in einem Großteil der gefertigten Bauteile an ein- und derselben Position regelmäßig ein Fehler gleichen Typs entsteht, so ist davon auszugehen, dass es sich hierbei um einen systematischen Fehler in der Fertigung handelt. Basierend auf einer solchen Agglomeration der Daten lassen sich so systematische Fehler identifizieren, die dann an die Recheneinheit 160 übertragen werden, woraufhin ein solcher systematischer Fehler ebenfalls in die dreidimensionale Repräsentation 200 projiziert werden kann, um sie so dem Benutzer anzuzeigen.

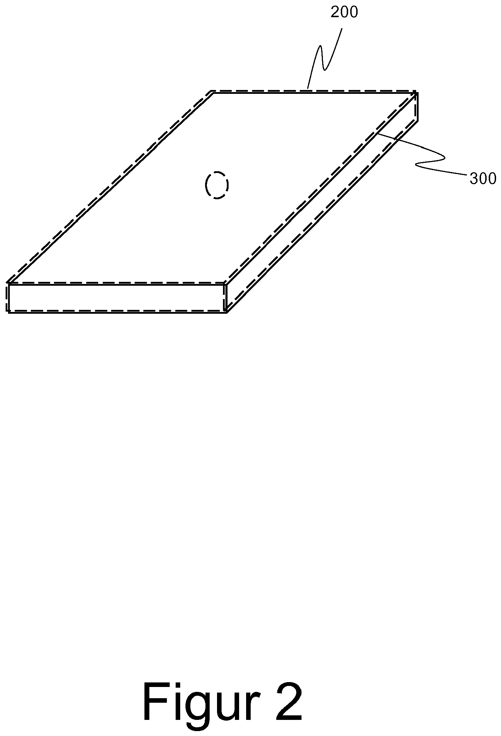

Figur 2 zeigt beispielhaft ein reales Bauteil 300, dem einen dreidimensionale virtuelle Repräsentation 200 mit Hilfe der Vorrichtung, wie sie in Figur 1 bekannt ist, überlagert wurde. Hierfür weist die Projektionsbrille 130 entsprechende Sensoren 180 auf (siehe Figur 1), mit der die Projektionsbrille 130 ihre eigene Position im Raum identifizieren kann. Hierdurch lässt sich beispielweise eine relative Position zu einem realen Bauteil 300 ableiten.

Basierend auf dieser relativen Position der Projektionsbrille 130 in Bezug zu dem realen Bauteil 300 lässt sich sodann die virtuelle Repräsentation 200 des Bauteils mit dem realen Bauteil in Deckung bringen, indem die Projektionsbrille 130 ihre Projektion so steuert, dass für den Benutzer der Projektionsbrille 130 der Eindruck entsteht, dass die dreidimensionale Repräsentation 200 direkt über dem realen Bauteil 300 liegt.

Werden nun in der dreidimensionalen Repräsentation 200 des Bauteils entsprechende Daten, wie beispielsweise Fehlerdaten, der Bauteildokumentation positionstreu innerhalb der dreidimensionalen Repräsentation 200 des Bauteils angezeigt, so befinden sich diese Daten auch positionstreu in Bezug auf das reale Bauteil 300, da die dreidimensionale Repräsentation 200 positionstreu mit dem realen Bauteil 300 in Deckung gebracht wurde.

Somit wird es möglich, dass der Benutzer der Projektionsbrille 130 sofort die Federposition am realen Bauteil 300 erkennen kann, ohne hier lange die entsprechende Fehlerposition suchen zu müssen.

Dies ist beispielsweise besonders dann vorteilhaft, wenn das Bauteil 300 ein großes, komplexes Faserverbundbauteil ist, wie beispielsweise eine Faserpreform vor dem Aushärten des Matrixmaterials und der darzustellende Fehler, ein Fehler von abgelegten Faserbahnen ist. Bei der Vielzahl von Faserbahnen bei einem großen Bauteil kann somit mit Hilfe der vorliegenden Erfindung erreicht werden, dass der Benutzer zielgerichtet auf die entsprechende Faserbahn aufmerksam gemacht wurde, bei der der entsprechende Fehler detektiert wurde, was zeitaufwändiges Suchen des Fehlers erspart.

### Bezugszeichenliste:

- 100: Vorrichtung
- 110: Datenspeicher
- 120: Bauteildokumentation
- 130: Projektionsbrille
- 140: Projektionsmodul
- 150: Projektionsgläser
- 160: Recheneinheit
- 170: Auswerteeinheit/Auswähleinheit
- 180: Lagesensoren
- 200: dreidimensionale Bauteilrepräsentation
- 210: Repräsentation der Daten
- 300: reales Bauteil

## Patentansprüche

1. Verfahren zur Darstellung einer Bauteildokumentation (120) bezüglich der Planung, Fertigung und/oder Wartung eines Bauteils, umfassend der Schritte:
- Bereitstellen einer in einem digitalen Datenspeicher (110) hinterlegten virtuellen Bauteildokumentation (120), die eine Mehrzahl von Planungs-, Fertigungs- und/oder Wartungsdaten bezüglich der Planung, Fertigung und/oder Wartung des Bauteils, die in einem jeweiligen Planungs-, Fertigungs- und/oder Wartungsprozess erfasst und dokumentiert wurden, sowie Modelldaten des Bauteils enthält,
- Bereitstellen einer Projektionsvorrichtung, die wenigstens eine Projektionsbrille (130) hat, die eine vor den Augen einer Person zu tragende Brillenkonstruktion ist und eine Projektion von virtuellen Abbildungen in die Umgebung des Blickfeldes der die Projektionsbrille (130) tragenden Person erzeugen kann,
- Erstellen einer dreidimensionalen Repräsentation des Bauteils aus den in der virtuellen Bauteildokumentation (120) enthaltenen Modelldaten des Bauteils mittels einer Recheneinheit (160),
- Projizieren der dreidimensionalen Repräsentation des Bauteils in die Umgebung des Blickfeldes der die Projektionsbrille (130) tragenden Person mittels der Projektionsbrille (130), und
- Darstellen zumindest eines Teils der Bauteildokumentation (120) bezüglich der Planung, Fertigung und/oder Wartung des Bauteils durch Projizieren eines Teils der Planungs-, Fertigungs- und/oder Wartungsdaten der hinterlegten virtuellen Bauteildokumentation (120) in die Umgebung des Blickfeldes der die Projektionsbrille (130) tragenden Person in Bezug zu der projizierten dreidimensionalen Repräsentation des Bauteils mittels der Projektionsbrille (130),
- **dadurch gekennzeichnet, dass** aus einer Mehrzahl von in dem digitalen Datenspeicher (110) hinterlegten Bauteildokumentationen (120) verschiedener Bauteile gleichen Typs mittels einer Auswerteeinheit (170) ein systematischer Fehler aus fehlerbezogenen Fertigungsdaten der jeweiligen Bauteildokumentationen (120) identifiziert wird, wobei dieser identifizierte systematische Fehler dargestellt wird, indem zumindest der systematische Fehler als fehlerbezogene Fertigungsdaten der Bauteildokumentation (120) positionstreu bezüglich dreidimensionalen Repräsentation eines der Bauteile in die Umgebung des Blickfeldes der Person mittels der Projektionsbrille (130) projiziert wird..

2. Verfahren nach Anspruch 1, **dadurch gekennzeichnet, dass** in der Bauteildokumentation (120) enthaltene fehlerbezogene Fertigungsdaten bezüglich des Fertigungsprozesses des Bauteils dargestellt werden, indem zumindest ein Teil der fehlerbezogenen Fertigungsdaten der Bauteildokumentation (120) positionstreu bezüglich dreidimensionalen Repräsentation des Bauteils in die Umgebung des Blickfeldes der Person mittels der Projektionsbrille (130) projiziert werden.

3. Verfahren nach Anspruch 1 oder 2, **dadurch gekennzeichnet, dass** mittels der bereitgestellten Projektionsvorrichtung die Position und Orientierung der Projektionsbrille (130) relativ zu einem realen Bauteil, dessen Bauteildokumentation (120) dargestellt werden soll, ermittelt wird, wobei die dreidimensionale Repräsentation des entsprechenden Bauteils derart in die Umgebung des Blickfeldes der die Projektionsbrille (130) tragenden Person projiziert wird, dass die dreidimensionale Repräsentation des Bauteils mit dem realen Bauteil in Deckung gebracht wird.

4. Verfahren nach einem der vorhergehenden Ansprüche, **dadurch gekennzeichnet, dass** mittels der bereitgestellten Projektionsvorrichtung die Position und/oder Orientierung der Projektionsbrille (130) relativ zu einem realen Bauteil und/oder absolut im Raum ermittelt wird, wobei Planungs-, Fertigungs- und/oder Wartungsdaten aus der hinterlegten virtuellen Bauteildokumentation (120) in Abhängigkeit von der ermittelten Position und/oder Orientierung der Projektionsbrille (130) durch eine Auswähleinheit (170) ausgewählt und die ausgewählten Planungs-, Fertigungs- und/oder Wartungsdaten in die Umgebung des Blickfeldes der die Projektionsbrille (130) tragenden Person mittels der Projektionsbrille (130) projiziert werden.

5. Verfahren nach einem der vorhergehenden Ansprüche, **dadurch gekennzeichnet, dass** Sprachausgaben und/oder Gestenbewegungen der die Projektionsbrille (130) tragenden Person mittels der bereitgestellten Projektionsvorrichtung erkannt werden, wobei die Projektionsvorrichtung bezüglich der Projektion in Abhängigkeit von den erkannten Sprachausgaben und/oder Gestenbewegungen gesteuert wird.

6. Verfahren nach einem der vorhergehenden Ansprüche, **dadurch gekennzeichnet, dass** Fertigungs- und/oder Wartungsdaten bezüglich des Bauteils mittels einer Sensorvorrichtung erfasst und Sprachausgaben und/oder Gestenbewegungen der die Projektionsbrille (130) tragenden Person mittels der bereitgestellten Projektionsvorrichtung erkannt werden, wobei die erfassten Fertigungs- und/oder Wartungsdaten in Abhängigkeit von den erkannten Sprachausgaben und/oder Gestenbewegungen in der Bauteildokumentation (120) hinterlegt werden.

7. Vorrichtung (100) zur Darstellung einer Bauteildokumentation (120) bezüglich der Planung, Fertigung und/oder Wartung eines Bauteils, wobei die Vorrichtung (100) zur Durchführung des vorstehend genannten Verfahrens ausgebildet ist und einen digitalen Datenspeicher (110) aufweist, in dem wenigstens eine virtuelle Bauteildokumentation (120), die eine Mehrzahl von Planungs-, Fertigungs- und/oder Wartungsdaten bezüglich der Planung, Fertigung und/oder Wartung des Bauteils, die in einem jeweiligen Planungs-, Fertigungs- und/oder Wartungsprozess erfasst und dokumentiert wurden, sowie Modelldaten des Bauteils enthält, hinterlegt ist, eine Projektionsvorrichtung hat, die wenigstens eine Projektionsbrille (130) hat, die eine vor den Augen einer Person zu tragende Brillenkonstruktion ist und zum Projizieren von virtuellen Abbildungen in die Umgebung des Blickfeldes der die Projektionsbrille (130) tragenden Person ausgebildet ist, eine Recheneinheit (160) hat, die zum Erstellen einer dreidimensionalen Repräsentation des Bauteils aus den in der virtuellen Bauteildokumentation (120) enthaltenen Modelldaten des Bauteils eingerichtet und zum Projizieren der erstellten dreidimensionalen Repräsentation des Bauteils in die Umgebung des Blickfeldes der die Projektionsbrille (130) tragenden Person mittels der Projektionsbrille (130) eingerichtet ist, wobei die Recheneinheit (160) zum Darstellen zumindest eines Teils der Bauteildokumentation (120) bezüglich der Planung, Fertigung und/oder Wartung des Bauteils durch Projizieren eines Teils der Planungs-, Fertigungs- und/oder Wartungsdaten der hinterlegten virtuellen Bauteildokumentation (120) in die Umgebung des Blickfeldes der die Projektionsbrille (130) tragenden Person in Bezug zu der projizierten dreidimensionalen Repräsentation des Bauteils mittels der Projektionsbrille (130) eingerichtet ist, **dadurch gekennzeichnet, dass** in dem digitalen Datenspeicher (110) eine Mehrzahl von Bauteildokumentationen (120) verschiedener Bauteile gleichen Typs hinterlegbar sind, wobei eine Auswerteeinheit (170) vorgesehen ist, die zum Identifizieren eines systematischen Fehlers aus fehlerbezogenen Fertigungsdaten der jeweiligen Bauteildokumentationen (120) ausgebildet ist, wobei die Recheneinheit (160) zum Projizieren dieses identifizierten systematischen Fehlers eingerichtet ist, indem zumindest der systematische Fehler als fehlerbezogene Fertigungsdaten der Bauteildokumentation (120) positionstreu bezüglich dreidimensionalen Repräsentation eines der Bauteile in die Umgebung des Blickfeldes der Person mittels der Projektionsbrille (130) projiziert wird.

8. Vorrichtung (100) nach Anspruch 7, **dadurch gekennzeichnet, dass** die Recheneinheit (160) zum Darstellen der in der Bauteildokumentation (120) enthaltene fehlerbezogene Fertigungsdaten bezüglich des Fertigungsprozesses des Bauteils eingerichtet ist, indem zumindest ein Teil der fehlerbezogenen Fertigungsdaten der Bauteildokumentation (120) positionstreu bezüglich dreidimensionalen Repräsentation des Bauteils in die Umgebung des Blickfeldes der Person mittels der Projektionsbrille (130) projiziert werden.

9. Vorrichtung (100) nach Anspruch 7 oder 8, **dadurch gekennzeichnet, dass** die Projektionsvorrichtung zum Ermitteln der Position und Orientierung der Projektionsbrille (130) relativ zu einem realen Bauteil, dessen Bauteildokumentation (120) dargestellt werden soll, ausgebildet ist, wobei die Recheneinheit (160) zum Projizieren der dreidimensionalen Repräsentation des entsprechenden Bauteils derart in die Umgebung des Blickfeldes der die Projektionsbrille (130) tragenden Person, dass die dreidimensionale Repräsentation des Bauteils mit dem realen Bauteil in Deckung gebracht wird, eingerichtet ist.

10. Vorrichtung (100) nach einem der Ansprüche 7 bis 9, **dadurch gekennzeichnet, dass** die Projektionsvorrichtung zum Ermitteln der Position und/oder Orientierung der Projektionsbrille (130) relativ zu einem realen Bauteil und/oder absolut im Raum ausgebildet ist, wobei die Recheneinheit (160) zum Auswählen von Planungs-, Fertigungs- und/oder Wartungsdaten aus einer hinterlegten virtuellen Bauteildokumentation (120) in Abhängigkeit von der ermittelten Position und/oder Orientierung der Projektionsbrille (130) und zum Projizieren der ausgewählten Planungs-, Fertigungs- und/oder Wartungsdaten in die Umgebung des Blickfeldes der die Projektionsbrille (130) tragenden Person mittels der Projektionsbrille (130) eingerichtet ist.

11. Vorrichtung (100) nach einem der Ansprüche 7 bis 10, **dadurch gekennzeichnet, dass** die Projektionsvorrichtung zum Erkennen von Sprachausgaben und/oder Gestenbewegungen der die Projektionsbrille (130) tragenden Person und zum Steuern der Projektionsvorrichtung bezüglich der Projektion in Abhängigkeit von den erkannten Sprachausgaben und/oder Gestenbewegungen eingerichtet ist.

12. Vorrichtung (100) nach einem der Ansprüche 7 bis 11, **dadurch gekennzeichnet, dass** eine Sensorvorrichtung vorgesehen ist, die zum Erfassen von Fertigungs- und/oder Wartungsdaten bezüglich des Bauteils ausgebildet ist, und die Projektionsvorrichtung zum Erkennen von Sprachausgaben und/oder Gestenbewegungen der die Projektionsbrille (130) tragenden Person ausgebildet ist, wobei die Recheneinheit (160) zum Hinterlegen der erfassten Fertigungs- und/oder Wartungsdaten in Abhängigkeit von den erkannten Sprachausgaben und/oder Gestenbewegungen in der Bauteildokumentation (120) eingerichtet ist.

## Claims

1. A method of representing a component documentation (120) relating to the planning, manufacture and/or maintenance of a component, with the steps:
- Providing of a virtual component documentation (120) stored in a digital data memory (110), which contains a plurality of planning, manufacture and/or maintenance data relating to the planning, manufacture and/or maintenance of the component, which were recorded and documented in a respective planning, manufacture and/or maintenance process, as well as model data of the component,
- Providing a projection device having at least one projection glasses (130), which is a glasses construction to be worn in front of a person's eyes and can generate a projection of virtual images into the environment of the field of view of the person wearing the projection glasses (130),
- Creating a three-dimensional representation of the component from the model data of the component contained in the virtual component documentation (120) by means of a computing unit (160),
- Projecting the three-dimensional representation of the component into the environment of the field of vision of the person wearing the projection glasses (130) by means of the projection glasses (130), and
- Representing at least a part of the component documentation (120) relating to the planning, manufacture and/or maintenance of the component by projecting a part of the planning, manufacture and/or maintenance data of the stored virtual component documentation (120) into the environment of the field of view of the person wearing the projection glasses (130) in relation to the projected three-dimensional representation of the component by means of the projection glasses (130),
- **characterized in that** a systematic defect is identified from defect-related manufacturing data of the respective component documentation (120) from a plurality of component documentations (120) of different components of the same type stored in the digital data memory (110) by means of an evaluation unit (170), this identified systematic defect being represented by projecting at least the systematic defect as defect-related manufacturing data of the component documentation (120) in a positionally accurate manner with respect to three-dimensional representation of one of the components into the environment of the person's field of vision by means of the projection glasses (130).

2. Method according to claim 1, **characterized in that** defect-related manufacturing data contained in the component documentation (120) are represented with respect to the manufacturing process of the component by projecting at least a part of the defect-related manufacturing data of the component documentation (120) in a positionally accurate manner with respect to three-dimensional representation of the component into the environment of the person's field of vision by means of the projection glasses (130).

3. Method according to claim 1 or 2, **characterized in that** the position and orientation of the projection glasses (130) relative to a real component whose component documentation (120) is to be displayed is determined by means of the projection device provided, the three-dimensional representation of the corresponding component being projected into the environment of the field of vision of the person wearing the projection glasses (130) in such a way that the three-dimensional representation of the component is brought into coincidence with the real component.

4. Method according to one of the preceding claims, **characterized in that** the position and/or orientation of the projection glasses (130) relative to a real component and/or absolute in space is determined by means of the projection device provided, planning, production and/or maintenance data being selected from the stored virtual component documentation (120) as a function of the determined position and/or orientation of the projection glasses (130) by a selection unit (170) and the selected projection glasses (130) being selected by a selection unit (170), planning, manufacture and/or maintenance data being selected from the stored virtual component documentation (120) as a function of the determined position and/or orientation of the projection glasses (130) by a selection unit (170) and the selected planning, manufacture and/or maintenance data being projected into the environment of the field of vision of the person wearing the projection glasses (130) by means of the projection glasses (130).

5. Method according to one of the preceding claims, **characterized in that** speech outputs and/or gesture movements of the person wearing the projection glasses (130) are recognized by means of the projection device provided, the projection device being controlled with respect to the projection as a function of the recognized speech outputs and/or gesture movements.

6. Method according to one of the preceding claims, **characterized in that** manufacturing and/or maintenance data relating to the component are recorded by means of a sensor device and voice outputs and/or gesture movements of the person wearing the projection glasses (130) are recognized by means of the projection device provided, the recorded manufacturing and/or maintenance data being stored in the component documentation (120) as a function of the recognized voice outputs and/or gesture movements.

7. Device (100) for displaying component documentation (120) relating to the planning, manufacture and/or maintenance of a component, the device (100) being designed to carry out the aforementioned method and having a digital data memory (110) in which at least one virtual component documentation (120), which contains a plurality of planning, manufacture and/or maintenance data relating to the planning, manufacture and/or maintenance of the component, which have been recorded and documented in a respective planning, manufacture and/or maintenance process, as well as model data of the component, is stored, has a projection device which has at least one projection glasses (130), which is a glasses construction to be worn in front of the eyes of a person and is designed to project virtual images into the environment of the field of vision of the person wearing the projection glasses (130), a computing unit (160), which is set up to create a three-dimensional representation of the component from the model data of the component contained in the virtual component documentation (120) and is set up to project the created three-dimensional representation of the component into the environment of the field of vision of the person wearing the projection glasses (130) by means of the projection glasses (130), wherein the computing unit (160) is arranged to display at least a part of the component documentation (120) relating to the planning, manufacture and/or maintenance of the component by projecting a part of the planning, manufacture and/or maintenance data of the stored virtual component documentation (120) into the environment of the field of view of the person wearing the projection glasses (130) in relation to the projected three-dimensional representation of the component by means of the projection glasses (130), **characterized in that** a plurality of component documentations (120) of different components of the same type can be stored in the digital data memory (110), whereby an evaluation unit (170) being provided which is designed to identify a systematic defect from defect-related production data of the respective component documentation (120), the computing unit (160) being set up to project this identified systematic defect by projecting at least the systematic defect as defect-related manufacturing data of the component documentation (120) in a positionally accurate manner with respect to three-dimensional representation of one of the components into the environment of the person's field of vision by means of the projection glasses (130).

8. Device (100) according to claim 7, **characterized in that** the computing unit (160) is set up for displaying the defect-related manufacturing data contained in the component documentation (120) with respect to the manufacturing process of the component, **in that** at least some of the defect-related manufacturing data of the component documentation (120) are projected with positional accuracy with respect to three-dimensional representation of the component into the environment of the person's field of vision by means of the projection glasses (130).

9. Device (100) according to claim 7 or 8, **characterized in that** the projection device is designed to determine the position and orientation of the projection glasses (130) relative to a real component whose component documentation (120) is to be displayed, the computing unit (160) being set up to project the three-dimensional representation of the corresponding component into the environment of the field of vision of the person wearing the projection glasses (130) in such a way that the three-dimensional representation of the component is brought into coincidence with the real component.

10. Device (100) according to one of claims 7 to 9, **characterized in that** the projection device is designed to determine the position and/or orientation of the projection glasses (130) relative to a real component and/or absolutely in space, the computing unit (160) being designed to select planning, production and/or maintenance data from a stored virtual component documentation (120) as a function of the determined position and/or orientation of the projection glasses (130) and to project the selected planning, manufacture and/or maintenance data from a stored virtual component documentation (120), production and/or maintenance data from a stored virtual component documentation (120) as a function of the determined position and/or orientation of the projection glasses (130) and for projecting the selected planning, manufacture and/or maintenance data into the environment of the field of vision of the person wearing the projection glasses (130) by means of the projection glasses (130).

11. Device (100) according to one of claims 7 to 10, **characterized in that** the projection device is set up for recognizing speech outputs and/or gesture movements of the person wearing the projection glasses (130) and for controlling the projection device with respect to the projection as a function of the recognized speech outputs and/or gesture movements.

12. Device (100) according to one of claims 7 to 11, **characterized in that** a sensor device is provided which is designed to detect manufacturing and/or maintenance data relating to the component, and the projection device is designed to detect voice outputs and/or gesture movements of the person wearing the projection glasses (130), the computing unit (160) being set up to store the detected manufacturing and/or maintenance data in the component documentation (120) as a function of the detected voice outputs and/or gesture movements.

## Revendications

1. Procédé de représentation d'une documentation de pièces (120) concernant la planification, la fabrication et/ou la maintenance d'une pièce, comprenant les étapes consistant à :
- fournir une documentation de pièces (120) virtuelle stockée dans une mémoire de données numérique (110), qui contient une pluralité de données de planification, de fabrication et/ou de maintenance concernant la planification, la fabrication et/ou la maintenance de la pièce, qui ont été saisies et documentées dans un processus de planification, de fabrication et/ou de maintenance respectif, ainsi que des données de modèle de la pièce,
- fournir un dispositif de projection ayant au moins une paire de lunettes de projection (130), qui est une construction de lunettes à porter devant les yeux d'une personne et qui peut générer une projection d'images virtuelles dans l'environnement du champ de vision de la personne portant les lunettes de projection (130),
- créer une représentation tridimensionnelle de la pièce à partir des données de modèle de la pièce contenues dans la documentation de pièces (120) virtuelle au moyen d'une unité de calcul (160),
- projeter la représentation tridimensionnelle de la pièce au moyen des lunettes de projection (130) dans l'environnement du champ de vision de la personne portant les lunettes de projection (130), et
- représenter au moins une partie de la documentation de pièces (120) concernant la planification, la fabrication et/ou la maintenance de la pièce par projection d'une partie des données de planification, de fabrication et/ou de maintenance de la documentation de pièces (120) virtuelle stockée, dans l'environnement du champ de vision de la personne portant les lunettes de projection (130), en relation avec la représentation tridimensionnelle projetée de la pièce au moyen des lunettes de projection (130),
**caractérisé en ce que**, à partir d'une pluralité de documentations de pièces (120) de différentes pièces de même type, stockées dans la mémoire de données numérique (110), une erreur systématique est identifiée à l'aide d'une unité d'évaluation (170) à partir des données de fabrication, relatives à l'erreur, des documentations de pièces (120) respectives, cette erreur systématique identifiée étant représentée en projetant, au moyen des lunettes de projection (130), au moins l'erreur systématique comme données de fabrication relatives à l'erreur de la documentation de pièces (120) dans l'environnement du champ de vision de la personne de manière fidèle à la position par rapport à la représentation tridimensionnelle de l'une des pièces.

2. Procédé selon la revendication 1,
**caractérisé en ce que** des données de fabrication relatives à l'erreur et contenues dans la documentation de pièces (120) sont représentées en ce qui concerne le processus de fabrication de la pièce, du fait qu'au moins une partie des données de fabrication relatives à l'erreur de la documentation de pièces (120) sont projetées dans l'environnement du champ de vision de la personne au moyen des lunettes de projection (130) de manière fidèle à la position par rapport à la représentation tridimensionnelle de la pièce.

3. Procédé selon la revendication 1 ou 2,
**caractérisé en ce que**, au moyen du dispositif de projection fourni, on détermine la position et l'orientation des lunettes de projection (130) par rapport à une pièce réelle dont la documentation de pièces (120) doit être représentée, la représentation tridimensionnelle de la pièce correspondante étant projetée dans l'environnement du champ de vision de la personne portant les lunettes de projection (130) de telle sorte que la représentation tridimensionnelle de la pièce est amenée à coïncider avec la pièce réelle.

4. Procédé selon l'une des revendications précédentes,
**caractérisé en ce que**, au moyen du dispositif de projection fourni, on détermine la position et/ou l'orientation des lunettes de projection (130) par rapport à une pièce réelle et/ou de manière absolue dans l'espace,
des données de planification, de fabrication et/ou de maintenance sont sélectionnées par une unité de sélection (170) à partir de la documentation de pièces (120) virtuelle stockée, en fonction de la position et/ou de l'orientation déterminée des lunettes de projection (130), et les données de planification, de fabrication et/ou de maintenance sélectionnées sont projetées, au moyen des lunettes de projection (130), dans l'environnement du champ de vision de la personne portant les lunettes de projection (130).

5. Procédé selon l'une des revendications précédentes,
**caractérisé en ce que** des instructions vocales et/ou des mouvements gestuels de la personne portant les lunettes de projection (130) sont reconnus au moyen du dispositif de projection fourni, le dispositif de projection étant commandé en ce qui concerne la projection en fonction des instructions vocales et/ou des mouvements gestuels reconnus.

6. Procédé selon l'une des revendications précédentes,
**caractérisé en ce que** des données de fabrication et/ou de maintenance concernant la pièce sont saisies au moyen d'un dispositif de détection, et des instructions vocales et/ou des mouvements gestuels de la personne portant les lunettes de projection (130) sont détectés au moyen du dispositif de projection fourni, les données de fabrication et/ou de maintenance saisies étant stockées dans la documentation de pièces (120) en fonction des instructions vocales et/ou des mouvements gestuels reconnus.

7. Dispositif (100) de représentation d'une documentation de pièces (120) concernant la planification, la fabrication et/ou la maintenance d'une pièce, le dispositif (100) étant conçu pour mettre en oeuvre le procédé susmentionné et comprenant une mémoire de données numérique (110) dans laquelle est stockée au moins une documentation de pièces (120) virtuelle, qui contient une pluralité de données de planification, de fabrication et/ou de maintenance concernant la planification, la fabrication et/ou la maintenance de la pièce, qui ont été saisies et documentées dans un processus de planification, de fabrication et/ou de maintenance respectif, ainsi que des données de modèle de la pièce, et comprenant un dispositif de projection qui présente au moins une paire de lunettes de projection (130), qui est une construction de lunettes à porter devant les yeux d'une personne et qui est conçue pour projeter des images virtuelles dans l'environnement du champ de vision de la personne portant les lunettes de projection (130), et comprenant une unité de calcul (160) conçue pour créer une représentation tridimensionnelle de la pièce à partir des données de modèle de la pièce contenues dans la documentation de pièces (120) virtuelle et pour projeter, au moyen des lunettes de projection (130), la représentation tridimensionnelle créée de la pièce dans l'environnement du champ de vision de la personne portant les lunettes de projection (130),
dans lequel
l'unité de calcul (160) est conçue pour représenter au moins une partie de la documentation de pièces (120), concernant la planification, la fabrication et/ou la maintenance de la pièce, par projection d'une partie des données de planification, de fabrication et/ou de maintenance de la documentation de pièces (120) virtuelle stockée, dans l'environnement du champ de vision de la personne portant les lunettes de projection (130), en relation avec la représentation tridimensionnelle projetée de la pièce, au moyen des lunettes de projection (130),
**caractérisé en ce que**
une pluralité de documentations de pièces (120) de différentes pièces de même type peuvent être stockées dans la mémoire de données numérique (110),
il est prévu une unité d'évaluation (170) conçue pour identifier une erreur systématique à partir des données de fabrication, relatives à l'erreur, des documentations de pièces (120) respectives, l'unité de calcul (160) étant conçue pour projeter cette erreur systématique identifiée en projetant, au moyen des lunettes de projection (130), au moins l'erreur systématique comme données de fabrication relatives à l'erreur de la documentation de pièces (120) dans l'environnement du champ de vision de la personne de manière fidèle à la position par rapport à la représentation tridimensionnelle de l'une des pièces.

8. Dispositif (100) selon la revendication 7,
**caractérisé en ce que** l'unité de calcul (160) est conçu pour représenter les données de fabrication relatives à l'erreur et contenues dans la documentation de pièces (120) en ce qui concerne le processus de fabrication de la pièce, du fait qu'au moins une partie des données de fabrication, relatives à l'erreur, de la documentation de pièces (120) sont projetées dans l'environnement du champ de vision de la personne au moyen des lunettes de projection (130) de manière fidèle à la position par rapport à la représentation tridimensionnelle de la pièce.

9. Dispositif (100) selon la revendication 7 ou 8,
**caractérisé en ce que** le dispositif de projection est conçu pour déterminer la position et l'orientation des lunettes de projection (130) par rapport à une pièce réelle dont la documentation de pièces (120) doit être représentée, l'unité de calcul (160) étant conçue pour projeter la représentation tridimensionnelle de la pièce correspondante dans l'environnement du champ de vision de la personne portant les lunettes de projection (130) de manière à faire coïncider la représentation tridimensionnelle de la pièce avec la pièce réelle.

10. Dispositif (100) selon l'une des revendications 7 à 9,
**caractérisé en ce que** le dispositif de projection est conçu pour déterminer la position et l'orientation des lunettes de projection (130) par rapport à une pièce réelle et/ou de manière absolue dans l'espace, l'unité de calcul (160) étant conçue pour sélectionner des données de planification, de fabrication et de maintenance à partir d'une documentation de pièces (120) virtuelle stockée, en fonction de la position et/ou de l'orientation déterminée des lunettes de projection (130), et pour projeter, au moyen des lunettes de projection (130), les données de planification, de fabrication et/ou de maintenance sélectionnées dans l'environnement du champ de vision de la personne portant les lunettes de projection (130).

11. Dispositif (100) selon l'une des revendications 7 à 10,
**caractérisé en ce que** le dispositif de projection est conçu pour reconnaître des instructions vocales et/ou des mouvements gestuels de la personne portant les lunettes de projection (130) et pour commander le dispositif de projection en ce qui concerne la projection en fonction des instructions vocales et/ou des mouvements gestuels reconnus.

12. Dispositif (100) selon l'une des revendications 7 à 11,
**caractérisé en ce qu'**il est prévu un dispositif de détection conçu pour saisir des données de fabrication et/ou de maintenance concernant la pièce, et le dispositif de projection est conçu pour reconnaître des instructions vocales et/ou des mouvements gestuels de la personne portant les lunettes de projection (130), l'unité de calcul (160) étant conçue pour stocker les données de fabrication et/ou de maintenance saisies dans la documentation de pièces (120) en fonction des instructions vocales et/ou des mouvements gestuels reconnus.
